# EUROPÄISCHE PATENTANMELDUNG

(11) **EP 2 402 991 A2**
(43) Veröffentlichungstag der Anmeldung: **04.01.2012**
(21) Anmeldenummer: 11168347.0
(22) Anmeldetag: 01.06.2011
(51) Int. Cl.: H01L 23/492, H01L 23/36, H01L 25/065

(54) **Halbleiterbauteil mit verbesserter Wärmeabfuhr**

(30) Priorität: 02.07.2010 DE 102010030838
(71) Anmelder: Robert Bosch GmbH, 70442 Stuttgart (DE)
(72) Erfinder: Hornung, Stefan, 70771 Leinfelden-Echterdingen (DE); Raica, Thomas, 72379 Hechingen (DE); Dillmann, Adolf, 72525 Muensingen (DE)

(57) **Zusammenfassung**

Die Erfindung betrifft ein Halbleiterbauteil, umfassend: ein erstes Halbleiterbauelement (2) und ein zweites Halbleiterbauelement (3), ein erstes Wärmeleitelement (11), ein zweites Wärmeleitelement (12), ein drittes Wärmeleitelement (13) und ein viertes Wärmeleitelement (14), wobei die Wärmeleitelemente thermisch und elektrisch leitende Eigenschaften aufweisen, wobei das erste Wärmeleitelement (11) an einer Oberseite und das zweite Wärmeleitelement (12) an einer Unterseite des ersten Halbleiterbauelements (2) angeordnet sind und wobei das dritte Wärmeleitelement (13) an einer Oberseite und das vierte Wärmeleitelement (14) an einer Unterseite des zweiten Halbleiterbauelements (3) angeordnet sind, einen Kühlkörper (15), welcher in Kontakt mit einem Kühlmedium (18) steht, wobei wenigstens eines der an der Oberseite der Halbleiterbauelemente angeordneten Wärmeleitelemente (11, 13) mit wenigstens einem der an der Unterseite der Halbleiterbauelemente angeordneten Wärmeleitelemente (12, 14) verbunden ist, und - wobei das zweite und vierte Wärmeleitelement mit dem Kühlkörper (15) verbunden ist.

## Beschreibung

### Stand der Technik

Die vorliegende Erfindung betrifft ein Halbleiterbauteil mit einer verbesserten Wärmeabfuhr.

Halbleiterbauteile sind aus dem Stand der Technik in unterschiedlichen Ausgestaltungen bekannt. Aufgrund der zunehmenden Leistungsdichte ergibt sich bei Halbleiterbauteilen zunehmend auch ein Problem bei der entsprechend notwendigen Wärmeabfuhr. Bei unzureichender Wärmeabfuhr kann dies zu Schäden an den Halbleiterbauelementen führen. Hierbei sind die bekannten Lösungen zur Wärmeabfuhr derart ausgestaltet, dass die Wärme, ausgehend vom Halbleiterbauelement in zwei entgegengesetzte Richtungen, jeweils von der Oberseite und der Unterseite abgeführt wird bzw. lediglich an einer Seite des Halbleiterbauelements, d.h. der Oberseite oder der Unterseite, abgeführt wird.

### Offenbarung der Erfindung

Das erfindungsgemäße Halbleiterbauteil mit den Merkmalen des Anspruchs 1 weist demgegenüber den Vorteil auf, dass Wärme in verbesserter Weise abgeführt werden kann. Ferner ermöglicht das erfindungsgemäße Halbleiterbauteil eine verbesserte Stromverteilung auf einer Oberseite von Halbleiterbauelementen, wie z.B. Leistungshalbleitern. Erfindungsgemäß kann die flächige Oberseite und die flächige Unterseite der Halbleiterbauelemente vollständig zur Abführung von Wärme verwendet werden. Weiterhin kann erfindungsgemäß auch eine Kontaktierung der Halbleiterbauelemente erfolgen. Dies wird erfindungsgemäß dadurch erreicht, dass das Halbleiterbauteil wenigstens zwei Halbleiterbauelemente und vier Wärmeleitelemente umfasst. Die Wärmeleitelemente haben dabei sowohl thermische als auch elektrisch leitende Eigenschaften. Die vier Wärmeleitelemente sind dabei derart an den beiden Halbleiterbauteilen angeordnet, dass das erste Wärmeleitelement an einer Oberseite des ersten Halbleiterbauelements und das zweite Wärmeleitelement an einer Unterseite des ersten Halbleiterbauelements angeordnet ist. Das dritte Wärmeleitelement ist an einer Oberseite des zweiten Halbleiterbauelements angeordnet und das vierte Wärmeleitelement ist an einer Unterseite des zweiten Halbleiterbauelements angeordnet. Ferner umfasst das Halbleiterbauteil einen Kühlkörper, welcher mit einem Kühlmedium in Kontakt steht. Erfindungsgemäß ist nun wenigstens eines der Wärmeleitelemente (d.h. das erste und/oder das dritte Wärmeleitelement), die an einer Oberseite der Halbleiterbauelemente angeordnet sind, mit wenigstens einem der Wärmeleitelemente (dem zweiten und/oder dem vierten Wärmeleitelement), welche an der Unterseite der Halbleiterbauelemente angeordnet sind, thermisch und elektrisch verbunden. Ferner sind die an der Unterseite der Halbleiterbauelemente befindlichen Wärmeleitelemente mit dem Kühlkörper verbunden. Erfindungsgemäß wird somit eine Umkehr eines Wärmestroms von zumindest einem der an der Oberseite angeordneten Wärmeleitelemente um 180° erreicht, wobei besonders bevorzugt die beiden an den Oberseiten der Halbleiterbauelemente angeordneten Wärmeleitelemente mit den an der Unterseite angeordneten Wärmeleitelementen verbunden sind. Somit kann an der Oberseite der Halbeleiterbauelemente eine U-förmige Wärmeführung erreicht werden, nämlich von der Oberseite des Halbleiterbauelements in das an der Oberseite angeordnete Wärmeleitelement und von diesem Wärmeleitelement wird die Wärme an ein unterseitiges Wärmeleitelement abgegeben. Erfindungsgemäß kann somit eine erhebliche Vereinfachung des Aufbaus erreicht werden, da ein Kühlkörper nur noch an einer Seite des Halbleiterbauteils angeordnet werden muss. Aufgrund der elektrischen Leitfähigkeit der Wärmeleitelemente kann auch gleichzeitig eine elektrische Kontaktierung der Oberseiten bzw. Unterseiten der Halbleiterbauelemente erreicht werden. Ferner können zur Wärmeabfuhr die gesamten Flächen der Oberseite und Unterseite der Halbleiterelemente verwendet werden können. Dies führt zu einer signifikanten Reduzierung der Herstellungskosten sowie auch einer Verringerung des notwendigen Bauraums für die Halbleiterbauteile.

Die Unteransprüche zeigen bevorzugte Weiterbildungen der Erfindung.

Vorzugsweise weist das erste Wärmeleitelement einen ersten Verbindungsbereich zur Verbindung mit dem vierten Wärmeleitelement auf und das dritte Wärmeleitelement weist einen zweiten Verbindungsbereich zur Verbindung mit dem zweiten Wärmeleitelement auf. Hierdurch ist es möglich, dass die gesamte Wärme von Oberseite und Unterseite an einer gemeinsamen Seite des Halbleiterbauteils abgegeben werden kann, so dass sich insbesondere für einen Kühlmittelstrom ein sehr einfacher Strömungsverlauf ergibt. Besonders bevorzugt sind die Verbindungsbereiche dabei an einem mittleren Bereich des Halbleiterbauteils angeordnet.

Für eine besonders gute Wärmeabfuhr und Kontaktierung überdecken die Wärmeleitelemente die gesamte Fläche an der Oberseite und der Unterseite der Halbleiterbauelemente.

Vorzugsweise sind die Wärmeleitelemente thermisch und elektrisch leitende Substrate, insbesondere Leiterplatten oder keramische Substrate, oder die Wärmeleitelemente sind Vollmetallelemente, insbesondere Kupferblöcke. Um einen besonders kompakten Aufbau zu erreichen, sind die Wärmeleitelemente derart ausgebildet, dass sie im Wesentlichen eine L-Form aufweisen.

Weiter bevorzugt umfasst das Halbleiterbauteil ein drittes Halbleiterbauelement, wobei ein einzelnes, gemeinsames Wärmeleitelement die Oberseiten oder Unterseiten der zweiten und dritten Halbleiterbauelemente verbindet.

Um einen sicheren und einfach und kostengünstig herstellbaren Kontakt zwischen den Halbleiterbauelementen und den Wärmeleitelementen zu ermöglichen, ist vorzugsweise zwischen jedem Wärmeleitelement und jedem Halbleiterbauelement eine Lötverbindung angeordnet.

Gemäß einer weiteren bevorzugten Ausgestaltung der Erfindung umfasst der Kühlkörper eine Kühlplatte aus einem Vollmaterial und in das Kühlmedium vorstehende Kühlelemente, insbesondere Rippen, Finnen, Pins, Wärmeleitbleche usw. Die Kühlplatte aus Vollmaterial kann hierbei insbesondere zusätzlich noch eine Wärmespeicherfunktion übernehmen. Darüber hinaus sorgt die Kühlplatte für eine gleichmäßige Wärmeverteilung zu den Kühlelementen und für eine schnelle Wärmeabfuhr von den Wärmeleitelementen.

Die Kühlplatte weist weiter bevorzugt einen Befestigungsbereich auf, um das Halbleiterbauteil an einem weiteren Bauteil, insbesondere einem Gehäuse o.Ä., zu befestigen. Da die Kühlplatte aus einem Vollmaterial hergestellt ist, kann eine Befestigung auf einfache Weise, beispielsweise durch Schraubverbindungen, Schweißverbindungen, z.B. durch Reibrührschweißen oder Ultraschallschweißen usw., erfolgen.

Vorzugsweise weist die Kühlplatte ferner einen Aufnahmebereich zur Aufnahme weiterer Komponenten, wie z.B. Kondensatoren, Busbars, Schaltungsträger, Gehäuseteile, EMV-Komponenten, Halteelemente usw. auf.

### Zeichnung

Nachfolgend werden bevorzugte Ausführungsbeispiele der Erfindung unter Bezugnahme auf die begleitende Zeichnung im Detail beschrieben. In der Zeichnung ist:
- Figur 1: eine schematische Schnittansicht eines Halbleiterbauteils gemäß einem ersten Ausführungsbeispiel der Erfindung,
- Figur 2: eine schematische Draufsicht eines Halbleiterbauteils gemäß einem zweiten Ausführungsbeispiel der Erfindung, und
- Figur 3: eine schematische Teil-Schnittansicht eines Halbleiterbauteils gemäß einem dritten Ausführungsbeispiel der Erfindung.
Bevorzugte Ausführungsformen der Erfindung

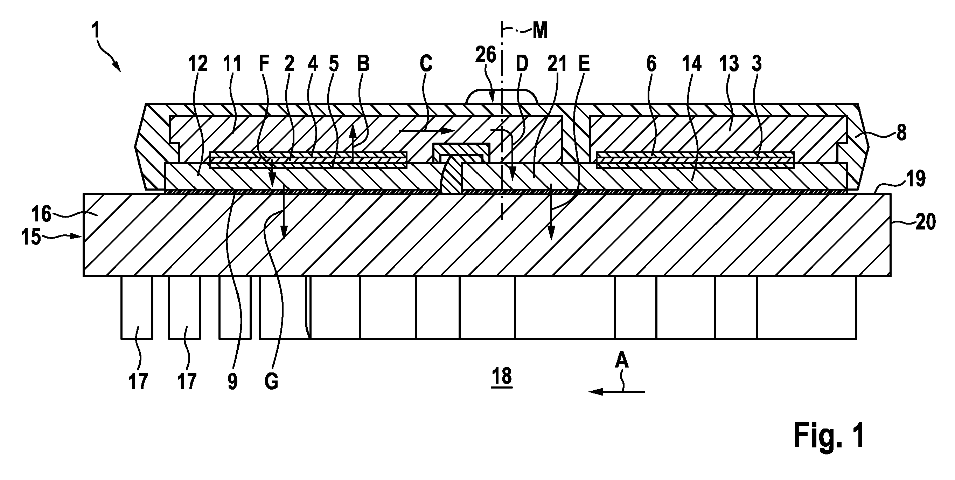

Nachfolgend wird unter Bezugnahme auf Figur 1 ein Halbleiterbauteil 1 gemäß einem ersten bevorzugten Ausführungsbeispiel der Erfindung im Detail beschrieben.

Wie aus Figur 1 ersichtlich ist, umfasst das Halbleiterbauteil 1 ein erstes Halbleiterbauelement 2 und ein zweites Halbleiterbauelement 3. Die beiden Halbleiterbauelemente sind beispielsweise Leistungshalbleiter.

Ferner umfasst das Halbleiterbauteil 1 ein erstes Wärmeleitelement 11, ein zweites Wärmeleitelement 12, ein drittes Wärmeleitelement 13 und ein viertes Wärmeleitelement 14. Wie aus Figur 1 ersichtlich ist, ist das erste Wärmeleitelement 11 mittels einer Lötverbindung 4 mit dem ersten Halbleiterbauelement 2 verbunden und das zweite Wärmeleitelement 12 ist über eine Lötverbindung 5 mit dem ersten Halbleiterbauelement 2 verbunden. In gleicher Weise ist das dritte Wärmeleitelement 13 und das vierte Wärmeleitelement 14 über Lötverbindungen 6 und 7 mit dem zweiten Halbleiterbauelement 3 verbunden. Die vier Wärmeleitelemente 11, 12, 13, 14 weisen dabei eine flächige Ausdehnung auf, welche größer ist als die flächige Ausdehnung der Halbleiterbauelemente 2, 3. Mit anderen Worten ist eine Fläche der Oberseiten und der Unterseiten der Halbleiterbauelemente 2, 3 kleiner als die Fläche der jeweiligen Wärmeleitelemente 11, 12, 13, 14.

Das Halbleiterbauteil 1 umfasst ferner einen Kühlkörper 15 mit einer Kühlplatte 16 aus Vollmaterial und einer Vielzahl von Kühlelementen 17 in Form von Wärmeleitflächen, welche an der nach außen gerichteten Seite der Kühlplatte 16 angeordnet sind. Die Kühlelemente 17 stehen in ein Kühlmedium 18 vor, welches, wie durch den Pfeil A gekennzeichnet, an den Kühlelementen 17 vorbeiströmt. Das Kühlmedium 18 ist beispielsweise Luft oder eine Kühlflüssigkeit. Das zweite Wärmeleitelement 12 und das vierte Wärmeleitelement 14 sind dabei über eine dünne Isolation 9 mit der Kühlplatte 16 verbunden, so dass die Wärmeleitelemente elektrisch von dem Kühlkörper 15 getrennt sind.

Wie weiter aus Figur 1 ersichtlich ist, umfasst das erste Wärmeleitelement 11 einen Verbindungsbereich 21, welcher eine direkte Verbindung mit dem vierten Wärmeleitelement 14 herstellt. Somit kann Wärme, welche von einer Oberseite des ersten Halbleiterbauelements 2 in das erste Wärmeleitelement 11 übertragen wird, über den Verbindungsbereich 21 in das vierte Wärmeleitelement 14 übertragen werden. Vom vierten Wärmeleitelement 14 kann die Wärme dann in den Kühlkörper 15 übertragen werden. Der Wärmestrom ist in Figur 1 durch die Pfeile B, C, D, E gekennzeichnet. Ferner kann vom ersten Halbleiterbauelement 2 Wärme auch direkt in das zweite Wärmeleitelement 12 und von dort in den Kühlkörper 15 (Pfeile F, G) übertragen werden. Somit erfolgt beim ersten Halbleiterbauelement 2 eine Umkehrung des Wärmestroms von der Oberseite des Halbleiterbauelements um 180°, so dass der Wärmestrom von der Oberseite und der Unterseite des ersten Halbleiterbauelements 2 einem gemeinsamen Kühlkörper 15 zugeführt werden kann. Somit kann beim Halbleiterbauteil 1 ein Kühlkörper 15 nur an einer Seite angeordnet werden.

Erfindungsgemäß ist somit eine mechanische, thermische und auch elektrische Anbindung von Halbleiterbauelementen, wie z.B. MOS-FET-Bauteilen, IGBC-Bauteilen, Dioden, Thyristoren oder BIP-Bauteilen möglich. Das Halbleiterbauelement 2 ist beidseitig flächig elektrisch und thermisch leitend angebunden. In diesem Ausführungsbeispiel sind Lötverbindungen vorgesehen, es können jedoch auch andere Arten von Verbindungen, wie beispielsweise Sinterverbindungen oder Klebeverbindungen, verwendet werden, solange diese elektrisch leitend sind. Ferner können statt der aus Kupfer bestehenden Wärmeleitelemente auch andere Wärmeleitelemente, beispielsweise in Form von Substraten (Leiterplatten, keramische Substrate o.Ä.) sowie durch Verwendung mechanischer Komponenten (z.B. metallische Stanzgitter, metallische Anschlussfahnen) oder Kombinationen daraus bereitgestellt werden. Ein Wärmeeintrag in den Kühlkörper 15 erfolgt dabei im Wesentlichen in einem mittigen Bereich M.

Am Kühlkörper 15 ist ferner ein Befestigungsbereich 20 vorgesehen, welcher seitlich an der Kühlplatte 16 angeordnet ist, sowie ein Befestigungsbereich 19, an welchem zusätzliche Bauteile befestigt werden können. Mit dem Bezugszeichen 26 sind ferner Einpresskontakte gekennzeichnet, mit denen eine Außenkontaktierung der Wärmeleitelemente ermöglicht wird.

Erfindungsgemäß kann somit ein besonders kompakter Aufbau des Halbleiterbauteils 1 bereitgestellt werden, welcher insbesondere auch niederinduktive Eigenschaften aufweist. Dabei kann Wärme in den Wärmeleitelementen und/oder in der Kühlplatte 16 aufgrund ihrer relativ großen Abmessungen zwischengespeichert werden. Die Umleitung des einen Wärmestroms um 180° ermöglicht somit eine parallele Wärmeabfuhr zu einer Seite, wodurch auch eine Führung des Kühlmediums 18 vereinfacht wird.

Zwischen dem dritten und vierten Wärmeleitelement 3, 4 und dem Kühlkörper 15 ist eine dünne Isolationsschicht 9 vorgesehen, und in diesem Ausführungsbeispiel schließt die Vergussmasse 8 die Halbleiterbauelemente und die Wärmeleitelemente vollständig ein. Die Isolation ist dabei möglichst dünn und weist möglichst gute Wärmeleiteigenschaften auf und kann aus allen elektrisch isolierenden Materialien bestehen, wie z.B. einer Keramik, einem isolierenden Klebstoff, einer Wärmeleitfolie, einer gefüllten Matrix oder Laminierfolien. Diese Isolationsschicht 9 stellt auch die Verbindung mit der sich anschließenden Kühlplatte 16 des Kühlkörpers 14 bereit.

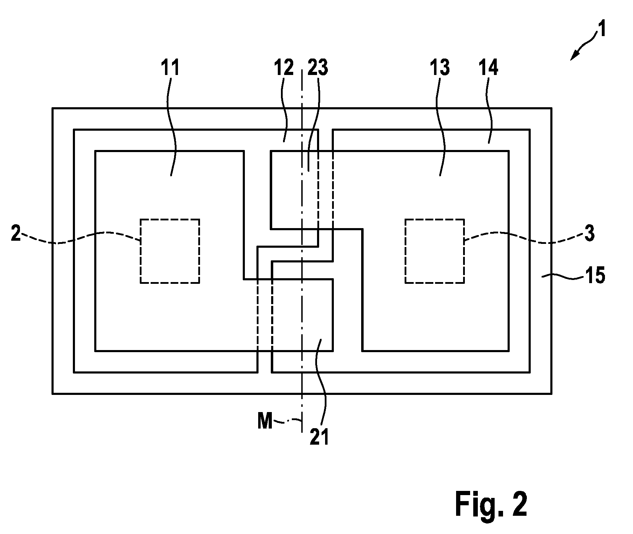

Nachfolgend wird unter Bezugnahme auf Figur 2 ein Halbleiterbauteil 1 gemäß einem zweiten Ausführungsbeispiel der Erfindung im Detail beschrieben. Dabei sind gleiche bzw. funktional gleiche Teile mit den gleichen Bezugszeichen wie im ersten Ausführungsbeispiel bezeichnet.

Im Unterschied zum ersten Ausführungsbeispiel wird beim zweiten Ausführungsbeispiel die Wärme von beiden Halbleiterbauelementen 2, 3 von der Oberseite um 180° umgeleitet und zum an der Unterseite angeordneten Kühlkörper 15 geführt. Hierzu ist wie im ersten Ausführungsbeispiel beim ersten Wärmeleitelement 11 der Verbindungsbereich 21 vorgesehen und beim dritten Wärmeleitelement 13 ein Verbindungsbereich 23. Der Verbindungsbereich 23 stellt eine Verbindung mit dem unterseitigen zweiten Wärmeleitelement 12 am ersten Halbleiterbauteil 2 bereit. Somit wird dem zweiten Wärmeleitelement 12 Wärme von der Unterseite des ersten Halbleiterbauelements 2 und Wärme von der Oberseite des zweiten Halbleiterbauelements 3 zugeführt. Dem vierten Wärmeleitelement 14 wird Wärme von der Unterseite des zweiten Halbleiterbauelements 3 und Wärme von der Oberseite des ersten Halbleiterbauelements 2 über den Verbindungsbereich 21 zugeführt. Somit wird bei diesem Ausführungsbeispiel die gesamte Wärme von den beiden Oberseiten der Halbleiterbauelemente und den beiden Unterseiten der Bauelemente in die gleiche Richtung zum Kühlkörper 15 abgeführt. Es sei angemerkt, da aufgrund der sehr guten Wärmeleitfähigkeit der Wärmeleitelemente 11, 12, 13, 14 relativ kleine Überlappungsbereiche zwischen den Wärmeleitelementen ausreichen, um einen zuverlässigen Wärmeübergang zu ermöglichen. Wie aus Figur 2 ersichtlich ist, wird der Wärmestrom von der Oberseite zur Unterseite in einem mittigen Bereich M zwischen den beiden Halbleiterbauelementen 2, 3 geführt. Hierdurch wird sichergestellt, dass der Wärmestrom im Wesentlichen mittig auf den Kühlkörper 15 trifft und von dort zu allen Seiten schnell und gleichmäßig abgeleitet werden kann. Dies ermöglicht eine besonders effektive Kühlung. Hierbei ist nur ein geringer zusätzlicher Bauraum zwischen den beiden Halbleiterbauelementen 2, 3 notwendig.

Ansonsten entspricht dieses Ausführungsbeispiel dem vorhergehenden Ausführungsbeispiel, so dass auf die dort gegebene Beschreibung verwiesen werden kann.

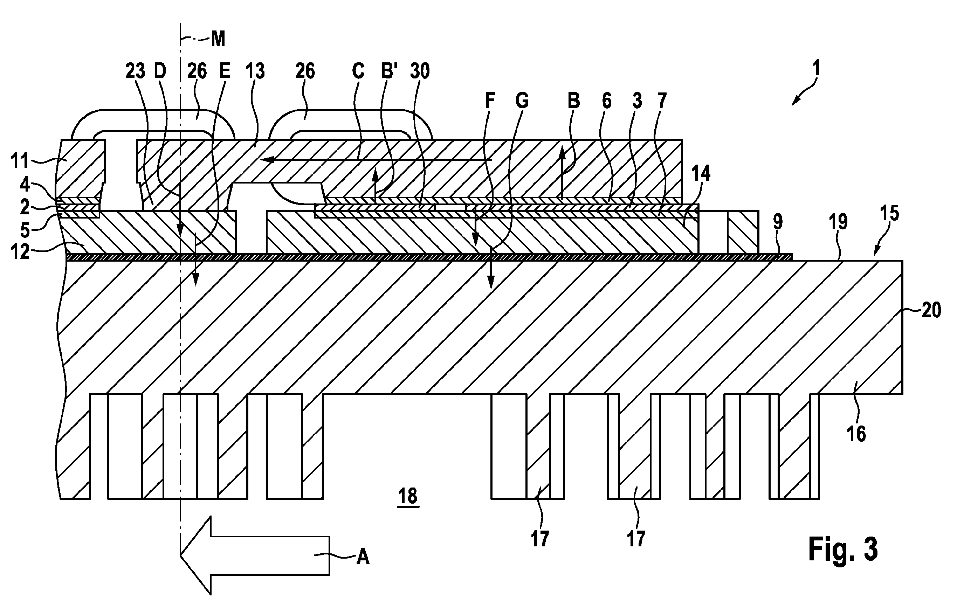

Figur 3 zeigt ein Halbleiterbauteil 1 gemäß einem dritten Ausführungsbeispiel der Erfindung, wo bei wiederum gleiche bzw. funktional gleiche Teile mit den gleichen Bezugszeichen, wie in den vorhergehenden Ausführungsbeispielen bezeichnet sind. Das dritte Ausführungsbeispiel weist zusätzlich noch ein drittes Halbleiterbauelement 30 auf, welches benachbart zum zweiten Halbleiterbauelement 3 angeordnet ist (vergleiche Figur 3). Über dem zweiten und dritten Halbleiterbauelement 3, 30 ist ein gemeinsames drittes Wärmeleitelement 13 vorgesehen, welches Wärme von beiden Halbleiterbauelementen 3, 30 aufnimmt (Pfeile B und B' in Figur 3). Die oberseitige Wärme der beiden Halbleiterbauelemente 3, 30 wird dann, wie durch die Pfeile C, D und E angedeutet, über den Verbindungsbereich 23 zum zweiten Wärmeleitelement 12 und von dort zum Kühlkörper 15 geleitet. Ferner ist eine separate Isolationsschicht 9 zwischen dem Kühlkörper 15 und dem zweiten Wärmeleitelement 12 bzw. dem vierten Wärmeleitelement 14 vorgesehen. In Figur 3 ist die das Halbleiterbauteil einschließende Vergussmasse 8 nicht dargestellt. Es sei angemerkt, dass das Halbleiterbauteil 1 gemäß dem dritten Ausführungsbeispiel sowohl entsprechend dem ersten Ausführungsbeispiel ausgebildet sein kann, d.h. dass die Wärme von einer der Oberseiten des ersten Halbleiterbauelements 2 über das erste Wärmeleitelement 11 nur nach oben abgegeben werden kann oder, dass das dritte Ausführungsbeispiel entsprechend dem zweiten Ausführungsbeispiel ausgebildet ist, d.h. dass das erste Wärmeleitelement 11 mit dem vierten Wärmeleitelement 14 verbunden ist.

## Patentansprüche

1. Halbleiterbauteil, umfassend:
- ein erstes Halbleiterbauelement (2) und ein zweites Halbleiterbauelement (3),
- ein erstes Wärmeleitelement (11), ein zweites Wärmeleitelement (12), ein drittes Wärmeleitelement (13) und ein viertes Wärmeleitelement (14), wobei die Wärmeleitelemente thermisch und elektrisch leitende Eigenschaften aufweisen,
- wobei das erste Wärmeleitelement (11) an einer Oberseite und das zweite Wärmeleitelement (12) an einer Unterseite des ersten Halbleiterbauelements (2) angeordnet sind und wobei das dritte Wärmeleitelement (13) an einer Oberseite und das vierte Wärmeleitelement (14) an einer Unterseite des zweiten Halbleiterbauelements (3) angeordnet sind,
- einen Kühlkörper (15), welcher in Kontakt mit einem Kühlmedium (18) steht,
- wobei wenigstens eines der an der Oberseite der Halbleiterbauelemente angeordneten Wärmeleitelemente (11, 13) mit wenigstens einem der an der Unterseite der Halbleiterbauelemente angeordneten Wärmeleitelemente (12, 14) thermisch und elektrisch verbunden ist, und
- wobei das zweite und vierte Wärmeleitelement mit dem Kühlkörper (15) verbunden ist.

2. Halbleiterbauteil nach Anspruch 1, **dadurch gekennzeichnet,**
- **dass** das erste Wärmeleitelement (11) einen ersten Verbindungsbereich (21) umfasst und über den ersten Verbindungsbereich (21) mit dem vierten Wärmeleitelement (14) verbunden ist, und
- **dass** das dritte Wärmeleitelement (13) einen zweiten Verbindungsbereich (23) umfasst und über den zweiten Verbindungsbereich (23) mit dem zweiten Wärmeleitelement (12) verbunden ist.

3. Halbleiterbauteil nach einem der vorhergehenden Ansprüche, **dadurch gekennzeichnet, dass** alle Wärmeleitelemente (11, 12, 13, 14) jeweils wenigstens die gesamte Fläche an der Oberseite und Unterseite der Halbleiterbauelemente (2, 3) überdecken.

4. Halbleiterbauteil nach einem der vorhergehenden Ansprüche, **dadurch gekennzeichnet, dass** die Wärmeleitelemente (11, 12, 13, 14) thermisch und elektrisch leitende Substrate, insbesondere Leiterplatten oder keramische Substrate, sind, oder dass die Wärmeleitelemente (11, 12, 13, 14) Vollmetallelemente, insbesondere Kupferelemente, sind.

5. Halbleiterbauteil nach einem der vorhergehenden Ansprüche, **dadurch gekennzeichnet, dass** eine Wärmeübertragung von einem Wärmeleitelement an einer Oberseite der Halbleiterbauelemente zu einem Wärmeleitelement an einer Unterseite der Halbleiterbauelemente in einem mittigen Bereich (M) des Halbleiterbauteils erfolgt.

6. Halbleiterbauteil nach einem der vorhergehenden Ansprüche, ferner umfassend ein drittes Halbleiterbauelement (30), wobei ein einzelnes, gemeinsames Wärmeleitelement (13) die Oberseiten und/oder die Unterseiten des zweiten und dritten Halbleiterbauelements (3, 30) verbindet.

7. Halbleiterbauteil nach einem der vorhergehenden Ansprüche, **dadurch gekennzeichnet, dass** zwischen jedem Wärmeleitelement (11, 12, 13, 14) und jedem Halbleiterbauelement (2, 3) eine Lötverbindung (4, 5, 6, 7) angeordnet ist.

8. Halbleiterbauteil nach einem der vorhergehenden Ansprüche, **dadurch gekennzeichnet, dass** der Kühlkörper (15) eine Kühlplatte (16) aus Vollmaterial und in das Kühlmedium (18) vorstehende Kühlelemente (17) aufweist.

9. Halbleiterbauteil nach Anspruch 8, **dadurch gekennzeichnet, dass** die Kühlplatte (16) einen Befestigungsbereich (20) umfasst, um das Halbleiterbauteil an einem weiteren Bauteil, insbesondere einem Gehäuse, zu befestigen.

10. Halbleiterbauteil nach Anspruch 8 oder 9, **dadurch gekennzeichnet, dass** die Kühlplatte (16) einen Aufnahmebereich (19) zur Aufnahme weiterer Komponenten aufweist.
